# EUROPEAN PATENT SPECIFICATION

(11) **EP 4 341 748 B1**
(45) Date of publication and mention of the grant of the patent: **25.11.2026**
(21) Application number: 22726373.8
(22) Date of filing: 12.05.2022
(51) Int. Cl.: G06F 1/16, G02F 1/1333, G09F 9/30, H04M 1/02, H05K 1/02, H10K 77/10

(54) **ACTIVE SLACK MANAGEMENT IN A LAYERED ARTICLE**
AKTIVES SPIELMANAGEMENT BEI EINEM GESCHICHTETEN ARTIKEL
GESTION ACTIVE DU MOU DANS UN ARTICLE EN COUCHES

(30) Priority: 19.05.2021 NL 2028249
(43) Date of publication of application: 27.03.2024
(73) Proprietor: Microsoft Technology Licensing, LLC, Redmond, WA 98052-6399 (US)
(72) Inventor: LARGE, Timothy Andrew, Redmond, Washington 98052-6399 (US); DIGHDE, Rajesh Manohar, Redmond, Washington 98052-6399 (US)
(74) Representative: Murgitroyd & Company
(86) International application number: PCT/US2022/072273
(87) International publication number: WO 2022/246371

(56) References cited:
- WO-A1-2017/058516
- US-A1- 2013 286 462
- US-A1- 2015 192 481
- US-A1- 2016 343 985
- US-A1- 2019 251 875
- US-A1- 2020 028 100

## Description

### FIELD

The specification relates to foldable device and in particular management of slack in a layered device.

### BACKGROUND

Demand has increased in recent years for electronic devices that are deformablee.g., flexible, bendable, or even foldable. For consumer electronics particularly, deformable electronic devices may be amenable to new and interesting use scenarios that more rigid devices exclude. Examples include compact electronic-display devices that fold open to present seamless display content across plural screens.
Reference is made to the documents US 2019/251875, US2015/192481, US2020/028100, WO 2017/058516 A1, US 2013/286462 A1 and US 2016/343985 A1 which have been cited as exemplary of the state of the art.

### SUMMARY

The scope of the invention is in accordance with the appended claims.

One aspect of this disclosure is directed to a bendable or otherwise flexible electronic-display device. The electronic-display device comprises an electrically conductive support layer, a display layer, a dielectric layer, and a drive circuit. The display layer includes an electrically conductive sublayer and is arranged slidably relative to the electrically conductive support layer. The dielectric layer is arranged intermediate the electrically conductive support layer and the electrically conductive sublayer. The drive circuit is configured to charge the electrically conductive sublayer relative to the electrically conductive support layer to operatively urge the display layer toward the electrically conductive support layer. Another aspect of this disclosure is directed to a bendable or otherwise flexible electronic-display device. The electronic-display device comprises an electrically conductive support layer, a display layer, a dielectric layer, a slack-reducing drive circuit, an electrodeformable layer, and a strain-relieving drive circuit. The display layer includes an electrically conductive sublayer and is arranged slidably relative to the electrically conductive support layer. The dielectric layer is arranged between the electrically conductive support layer and the electrically conductive sublayer. The slack-reducing drive circuit is configured to charge the electrically conductive sublayer relative to the electrically conductive support layer to operatively urge the display layer toward the electrically conductive support layer. The electrodeformable layer is configured to deform dimensionally under a varying electrical bias; it includes two or more electrodes configured to receive the varying electrical bias. The strain-relieving drive circuit is configured to supply the varying electrical bias to the two or more electrodes to operatively induce a dimensional change in the electrodeformable layer that relieves bending strain in the display layer.

Another aspect of this disclosure is directed to a method to reduce slack in a display layer of a bendable or otherwise flexible electronic-display device. The method comprises arranging the display layer slidably relative to an electrically conductive support layer of the electronic-display device; arranging a dielectric layer between the electrically conductive support layer and an electrically conductive sublayer of the display layer; and charging the electrically conductive sublayer relative to the electrically conductive support layer, thereby urging the display layer toward the electrically conductive support layer.

This Summary is provided to introduce in simplified form a selection of concepts that are further described in the Detailed Description. This Summary is not intended to identify key features or essential features of the claimed subject matter, nor is it intended to be used to limit the scope of the claimed subject matter. The claimed subject matter is not limited to implementations that solve any or all disadvantages noted in any part of this disclosure.

### BRIEF DESCRIPTION OF THE DRAWINGS

FIGS. 1 and 2 show aspects of example foldable articles comprising a stack of material layers.
FIGS. 3A, 3B, and 4 show aspects of example foldable electronic-display devices.
FIG. 5 shows aspects of an example strain-sensitive display layer of an electronic-display device having an active-matrix organic light-emitting diode (AMOLED) display.
FIG. 6 shows aspects of an example strain-sensitive display layer of an electronic-display device having a liquid-crystal display (LCD).
FIGS. 7A, 7B, and 7C show additional aspects of the example foldable electronic-display device of FIG. 4.
FIG. 8 shows a graph of relative elongation versus electrical bias for an electrodeformable layer of a foldable article.
FIG. 9 shows aspects of an example method to relieve bending strain in a display layer of an electronic-display device.
FIGS. 10A and 10B show aspects of another foldable electronic-display device.
FIG. 11 shows aspects of an example method to reduce slack in a display layer of a foldable electronic-display device.
FIG. 12 shows aspects of an example integrated computer system of an electronic-display device.

### DETAILED DESCRIPTION

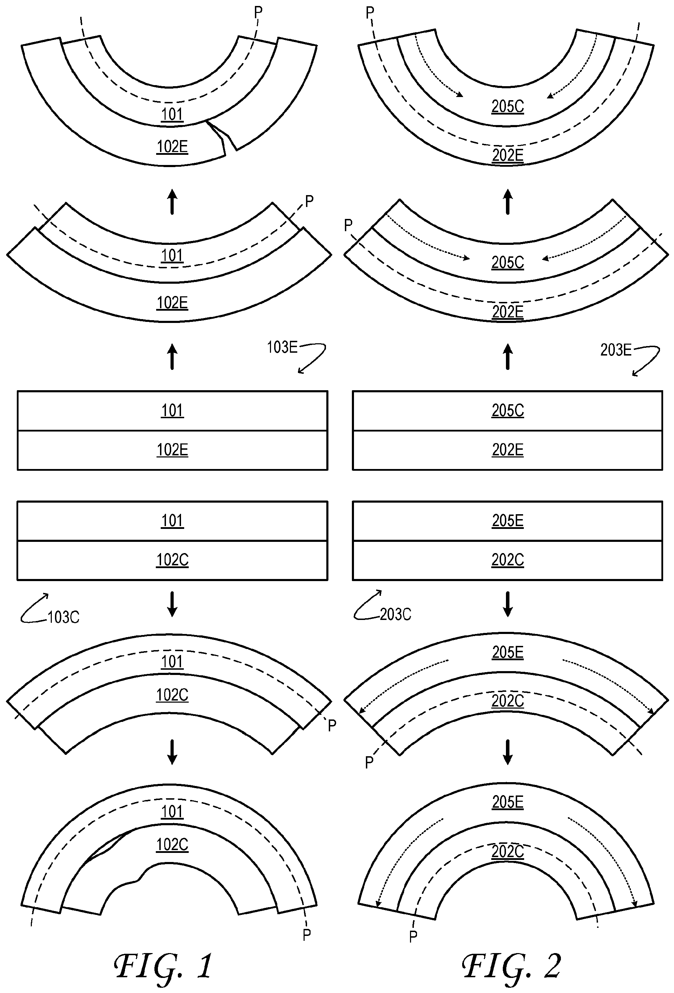

A flexible electronic device, such as a flexible electronic-display device, may comprise a stack of relatively thin material layers. If the electronic device is to remain functional and cosmetically acceptable during and after flexion, then each layer of the stack must survive the strain induced by the flexion; this includes any layer in which electronic componentry is arranged. One mode of flexion is the mode of bending about an axis. The strain from bending on each material layer of a layered article depends on the elevation of that layer relative to the so-called 'neutral plane' of the article-*i.e*., the imaginary, bendable interface that neither expands nor contracts during the bend. In FIG. 1, neutral plane *P* passes through layer 101 of flexible articles 103E and 103C. In both articles, accordingly, layer 101 experiences relatively little strain on bending. By contrast, layer 102E, situated below (*i.e*., behind) the neutral plane, experiences expansion strain. Layer 102C, situated above (*i.e*., in front of) the neutral plane, experiences compression strain. As shown in FIG. 1, expansion strain above the elastic limit of layer 102E may cause yield failure, and compression strain above the elastic limit of layer 102C may cause delamination failure.

Ideally it would be desirable to engineer any flexible, layered article so that the neutral plane passes through the most strain-sensitive material layer, which, for an electronic device, may be a layer in which strain-sensitive electronic componentry is arranged. That approach may not always be possible, however, because in any practical device the thickness of each layer is a product of manufacturing and design constraints. Further, the elevation of the neutral plane depends on the stiffness of the various layers and may vary with the degree of bending along a bending mode.

In view of the above issues, an active strain-management solution is presented herein. In particular, if at least one of the material layers of a layered article is not dimensionally fixed, but controllably deformable perpendicular to its thickness direction, then it becomes possible to control the elevation of the neutral plane within that article. Such control may be exerted during and maintained after bending of the article. In that manner, the neutral plane may be confined to a pre-determined strain-sensitive layer, thereby protecting that layer from excessive strain. In FIG. 2, controllably deformable layer 205C is made to contract during the bending of article 203E, which protects strain-sensitive layer 202E from expansion strain. Likewise, controllably deformable layer 205E is made to expand during the bending of article 203C, thereby protecting strain-sensitive layer 202C from compression strain. This principle can be a basis for active strain management in various flexible articles and electronic devices; it is especially suited to flexible electronic-display devices, which may include a strain-sensitive thin-film transistor (TFT) sublayer. The drawings and description hereinafter illustrate active strain management for this important example but further demonstrate how the disclosed solution can be applied more generally to any layered article subject to flexion.

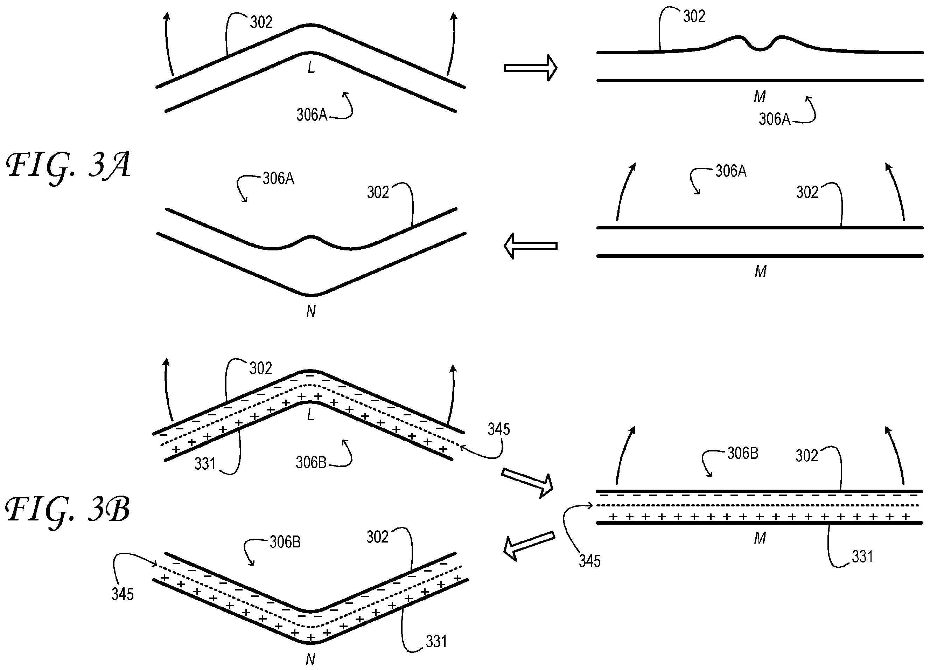

In these and other examples, the overall strain-management solution may leverage substantially slidable coupling between the strain-sensitive display layer and adjacent layers. An undesired collateral effect may emerge, however, when device layers are permitted to slide relative to each other. FIG. 3A shows a layered device 306A having a slidably coupled display layer 302-*e.g*., an electronic-display layer or other top layer. In a scenario in which the layered device has been in conformation *L* for an extended period of time, the various layers within the device may reach a static equilibrium. The act of abruptly unfolding the device into conformation *M* may disrupt that equilibrium, causing the display layer to bulge or wrinkle. Likewise, the layers within the device may reach a static equilibrium in conformation *M*, such that abruptly folding into conformation *N* causes the display layer to bulge or wrinkle.

In view of this issue, an active slack-management solution is presented herein. In particular, in a layered device where one of the layers in the device is an electrically conductive support layer and where the display layer comprises an electrically conductive sublayer, then it is possible to electrostatically charge the electrically conductive sublayer relative to the electrically conductive support layer, as shown in FIG. 3B. Electrostatic charging urges the display layer toward the electrically conductive support layer, thereby preventing any bulge or wrinkle from forming in the display layer. Such charging may be enacted continuously in some examples, or during selected conditions, such as when excessive slack in the display layer is sensed, or pursuant to a change in the opening angle of the device. In that manner, the display layer may be firmly flattened against underlying layers, providing high-quality presentation at any value of the opening angle.

This disclosure concerns manufactured articles having various modes and degrees of deformability. In general, the deformable articles herein are 'flexible' articles. Some of the flexible articles may be twistable, and some may be bendable. A bendable article is described as 'foldable' if that article is bendable over a radius of curvature which is small relative to its length or width. A bendable article is described as 'rollable' if that article can be bent to a constant or smoothly varying radius of curvature, over a length which is large relative to the radius of curvature. A rollable article, if sufficiently long, can be rolled over itself, in a jellyroll configuration. In some examples, the flexible, twistable, bendable, foldable, and/or rollable articles herein may comprise wearable articles and/or functional textiles. In some examples, the flexible, twistable, bendable, foldable, and/or rollable articles may comprise electronic-display devices.

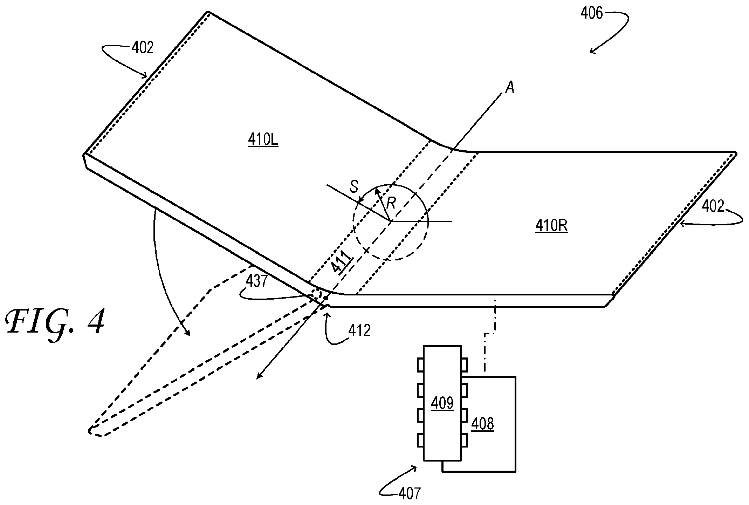

FIG. 4 shows aspects of an example flexible electronic-display device 406. With relative dimensions as illustrated, device 406 may embody a smartphone, personal digital assistant, mini-tablet computer, media player, or handheld game system. With different relative dimensions, device 406 may embody a tablet or laptop computer, peripheral computer monitor, all-in-one computer system, or virtually any other type of electronic-display device. In examples that include an integrated or peripheral computer 407, the computer may include at least one processor 408 and associated computer memory 409. The computer memory may hold instructions that cause the processor to enact any of the methods disclosed herein.

Flexible electronic-display device 406 includes a display layer 402. In some examples, the display layer may support a touch sensor. Display layer 402 has a right plane section 410R, an opposing left plane section 410L, and a flex section 411 bridging the right and left plane sections. Arranged in front of hinge portion 412 of device 406, flex section 411 of display layer 402 is bendable. Further, in the illustrated example the flex section is foldable about axis A at radius of curvature *R*. Intersection of the respective geometric planes of plane section 410R and of plane section 410L defines an opening angle (or hinge angle) *S*, where *S* = 0 if the plane sections of display layer 402 are face-to-face, *S* = 180 degrees if the plane sections lay flat, and *S* = 360 degrees if the plane sections are back-to-back. It will be understood that some of the flexible articles herein may not support a full 360-degree rotation about the fold axis, while others may. In the example illustrated in FIG. 4, electronic-display device 406 includes a hinge-angle sensor 437 that furnishes an output responsive to the opening angle *S*, or to any suitable surrogate, so that the opening angle may be used as a control input in the methods herein. The hinge-angle sensor may comprise an electrooptical, electromechanical, or electromagnetic (*e.g.*, Hall-effect) senor, for instance.

In some examples, as noted above, flex section 411 may be configured to bend so as to allow rotation of opposing plane sections 410 from 0 to as much as 180 degrees in S. In some examples, flex section 411 is configured to bend so as to allow rotation of the opposing plane sections from 0 to as much as 360 degrees in *S*. In other words, the plane sections may fold back upon themselves, in a back-to-back conformation. At a minimum, flex section 411 may include a plurality of electrical conductors joining the opposing plane sections 410; these conductors must remain intact during and after folding. Further, in some examples, display layer 402 is configured to provide a seamless display that wraps from the right to the left plane section through the flex section. In such examples, the flex section includes *active* display componentry that must be protected from excessive strain during and after folding.

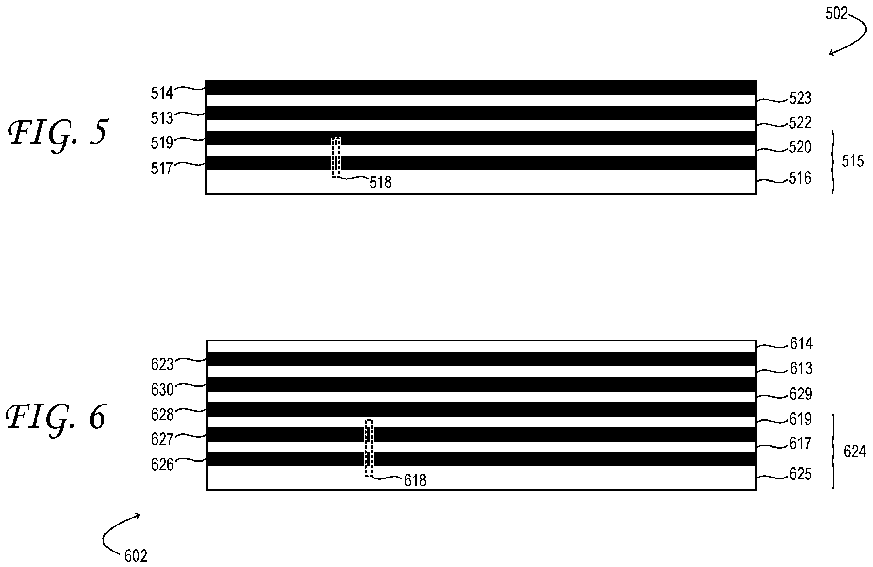

Display layer 402 of electronic-display device 406 may comprise a flexible liquid-crystal display (LCD), an active-matrix organic light-emitting diode (AMOLED) display, a passive-matrix organic light-emitting diode (PMOLED) display, a micro-LED display, or virtually any other kind of flexible electronic display. FIGS. 5 and 6 show additional aspects of two different example display layers that may be arranged in device 406, extending from either or both plane sections 410 through flex section 411. Each of the illustrated display layers includes a plurality of sublayers.

Display layer 502 of FIG. 5 includes a capacitive touch sensor 513 arranged behind transparent cover sublayer 514, and AMOLED display 515 arranged behind the capacitive touch sensor. In examples implementing touch-on-encapsulation (TOE), capacitive touch-sensor functionality may be integrated into the pixel elements (*vide infra*), such that a dedicated touch-sensor sublayer is not necessary. AMOLED display 515 includes a substrate 516 supporting a thin-film transistor (TFT) array 517. The TFT array includes at least one TFT arranged at the crossing of each horizontal and vertical scan line of the display; this TFT addresses (charges and discharges) the pixel element 518 arranged at that crossing. In some examples, a second TFT may be associated with each pixel element and configured to maintain the current through that pixel element for the duration of the AMOLED refresh interval. AMOLED display 515 also includes an optically transparent common electrode (or cathode) 519 and an electroluminescent organic layer 520 arranged between the TFT array and the common electrode. In polychromatic AMOLED displays, the electroluminescent organic layer may include at least three different luminophores segregated into different pixel elements in a repeating, macropixel pattern. In FIG. 5, common electrode 519 is bonded to capacitive touch sensor 513 via a sublayer 522 of optically clear adhesive (OCA). A second sublayer 523 of OCA may be used to bond capacitive touch sensor 513 to transparent cover sublayer 514.

Display layer 602 of FIG. 6 includes a capacitive touch sensor 613 arranged behind transparent cover sublayer 614, with LCD 624 arranged behind the capacitive touch sensor. In FIG. 6, backlighting for LCD 624 originates in light-guide plate (LGP) 625 and illuminates polarizer 626 via a series of reflectors, diffusers, and/or prismatic films. Polarizer 626 selects light of a desired polarization state for entry into TFT array 617. TFT array 617 supports a nematic liquid-crystal film 627 capable of selectively rotating the plane of polarization of the backlighting in response to external bias applied to the individual lightreleasing pixel elements 618 of the TFT array. The nematic liquid-crystal film is bounded on the opposite side by optically transparent common electrode 619. Polarized light from each pixel element passes through the common electrode and through color-filter (CF) 628, which includes an array of CF elements positioned in registry with the pixel elements 618, and then through second polarizer 629 where light of the undesired polarization state is blocked. The second polarizer is bonded to capacitive touch sensor 613 by via sublayer 630 of optically clear adhesive (OCA).

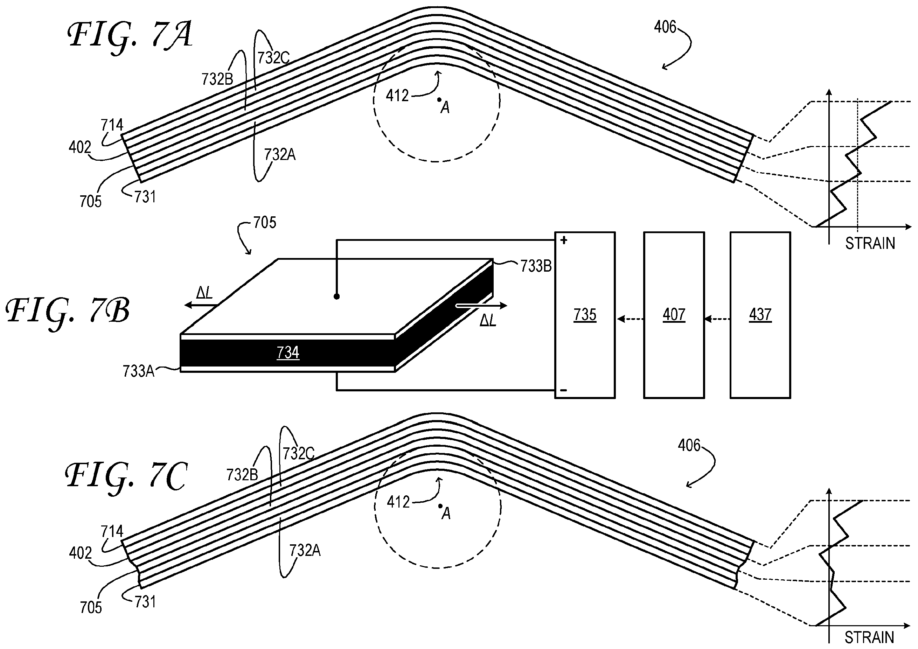

FIGS. 7A, 7B, and 7C show additional aspects of flexible electronic-display device 406, which comprises a plurality of material layers stacked upon each other, each material layer being much thinner than the length or width of that material layer. Arranged toward the back of device 406, metal support layer 731 provides structural support for the device. In some examples, the metal layer may be perforated and/or corrugated in hinge portion 412 to enable folding about fold axis A. In some examples the metal layer may comprise steel. In the illustrated example, a cover layer 714 is arranged on the front of device 406. In some examples, the cover layer may comprise glass. In other examples, the cover layer may comprise a hard, transparent polymer, such as colorless polyimide.

Situated among the plurality of material layers of flexible electronic-display device 406 is strain-sensitive display layer 402. As noted above, display layers based on LCD or AMOLED technology comprise a strain-sensitive TFT sublayer. In device 406, display layer 402 is partially protected from strain by elastic layers 732 (*e.g*., 732A, 732B, 732C). Here the elastic layer may take the form of an adhesive that optionally includes a hyperelastic and/or visco-elastic material. A hyperelastic material may accommodate an elastic strain of several hundred percent, for instance, while exerting limited stress on adjacent layers. In some examples, the level of strain relief provided by one or more elastic layers may partly relieve the compressive strain on display layer 402 when the article is folded closed-*i.e*., from 180 to 0 degrees in *S*, at a suitable radius of curvature. This aspect is evident from the idealized plots of strain versus elevation in FIGS. 7A and 7B, in which the slope is negative within each of the elastic layers. Nevertheless, the one or more elastic layers may provide insufficient relief of expansion strain on display layer 402, which may occur when the device 406 is folded back on itself-*i.e*., from 0 to as much as 360 degrees in *S*. Under such conditions, the only neutral plane in the structure (the elevation at which the strain is zero) is situated well behind display layer 402. Thus the display layer is subject to excessive expansion strain and may yield to it.

To address this issue and to provide still other advantages, flexible electronic-display device 406 includes an electrodeformable layer 705 configured to deform dimensionally under varying electrical bias (*e.g*., electric field, voltage, current, or charge). Electrodeformable layer 705 is arranged between and sandwiched by elastic layers 732A and 732B in the illustrated example. As shown in FIG. 7B, the electrodeformable layer includes a pair of control electrodes 733 (*viz.,* 733A, 733B) configured to receive a varying electrical bias. Under opposing electrical bias, control electrodes 733 exert an electric field across electrodeformable material 734, which causes the electrodeformable material to variably and controllably deform commensurate with the strength of the electric field. Strain-relieving drive circuit 735 of FIG. 7B is configured to supply the varying electrical bias to the control electrodes, thereby inducing the dimensional change in electrodeformable layer 705 that relieves the flexion (*e.g*., bending or folding) strain in strain-sensitive display layer 402. In some examples, control electrodes 733 comprise metal film arranged on opposite sides of electrodeformable material 734, as shown in FIG. 7B. Here the opposing electrical bias causes the electrodeformable material to compress in the thickness direction, thereby causing a commensurate expansion Δ*L* perpendicular to the thickness direction. The control electrodes may areally cover the opposite sides of the electrodeformable material in some examples. Although the varying electrical bias may be supplied across the thickness of electrodeformable material 734, other biasing geometries are also envisaged. One alternative electrode configuration includes opposing series of interdigitated electrodes running the length or width of opposing faces of the electrodeformable layer. In that configuration, the first, third, fifth, etc., electrode in each series may be biased positively, and the second, fourth, sixth, *etc*., electrode in each series may be biased negatively. Here the opposing electrical bias directly causes a contraction in the direction along which the series is arranged. Interdigitated electrodes can be materially configured to resist breakage due to dimensional change in the electrodeformable material.

In FIG. 7A, electrodeformable layer 705 is unbiased and therefore retains its engineered dimensions through the folding operation. In FIG. 7C, by contrast, the electrodeformable layer is electrically biased via control electrodes 733 such that the electrodeformable layer contracts during the obtuse-folding operation. Deformation of electrodeformable layer 705 in this manner relieves the expansion strain in strain-sensitive display layer 402, as can be seen from the plot of FIG. 7C, where a neutral plane passes through strain-sensitive display layer 402.

The particular dimensional deformation useful for relieving strain in a strain-sensitive layer depends on: (a) the relative elevations of the strain-sensitive layer and the electrodeformable layer within the layered article, and (b) the type of strain to be actively managed-*e.g*., compression strain, expansion strain, or both. In electronic-display devices in which plural material layers are configured to fold about an axis, it may be convenient to position the strain-sensitive display layer between the electrodeformable layer and the fold axis, as shown in FIGS. 7A and 7C. This configuration alleviates any need for the electrodeformable layer, including the control electrodes, to be optically transparent. In such examples, where further the actively managed strain on the strain-sensitive layer is an expansion strain, the electrodeformable layer may be configured to contract in response to varying the electrical bias. In otherwise similar examples, but where the actively managed strain on the strain-sensitive layer is a compression strain, the electrodeformable layer may be configured to expand in response to the varying electrical bias. In still other examples, the electrodeformable layer may comprise optically transparent indium-tin oxide (ITO) or microwire mesh and may be arranged in front of the display layer. There, dimensional contraction of the electrodeformable layer may be used to protect the strain-sensitive display layer from compressive strain, and dimensional expansion of the electrodeformable layer may be used to protect the display layer from expansion strain.

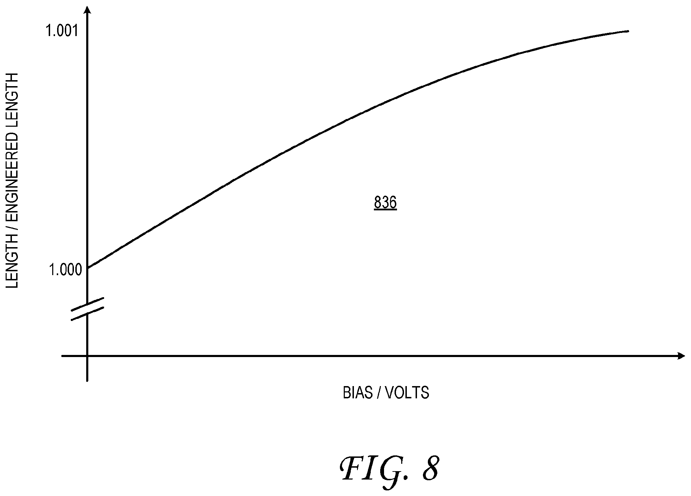

In some examples, electrodeformable material 734 may be engineered to exhibit a length-to-applied-bias characteristic roughly as shown at 836 in FIG. 8. Strain-relieving drive circuit 735 may be configured to provide the varying electrical bias in any portion of the domain of characteristic 836 in order to achieve any desired dimensional change, whether it be expansion or contraction. In examples in which the electrodeformable layer is required only to expand relative to its length in the laid-open (*S* = 0) state, the electrodeformable layer may be unbiased in the laid-open state. In examples in which the electrodeformable layer is required to contract, the electrodeformable layer may be biased to a predetermined value in the laid open state, and that bias may be reduced commensurate with the contraction required.

In order to sense the direction and amount of deformation of electrodeformable layer 705 required for strain relief, electronic-display device 406 may include a sensor responsive to stress or strain in display layer 402, or any other strain-sensitive layer. Via appropriate control logic of computer 407, strain-relieving drive circuit 735 may be configured to vary the electrical bias in dependence on the output of the stress or strain sensor, or on any other correlated parameter. For example, the opening angle *S* of electronic-display device 406 may be highly correlated to the stress or strain. In the example illustrated in FIG. 7B, hinge-angle sensor 437 furnishes an output responsive to the opening angle *S*, so that the opening angle may be used as a control input to control the level of bias on electrodeformable layer 705. Thus, strain-relieving drive circuit 735 may be configured to vary the electrical bias in dependence on the opening angle or any suitable surrogate. In other examples, the opening angle may be assessed indirectly, via other sensory componentry of the electronic-display device, or heuristically based on the current use scenario.

The composition of electrodeformable material 734 is not particularly limited. In some examples, the electrodeformable material may include a piezoelectric polymer film-*e.g*., a polyvinylidene fluoride (PVDF) film uniaxially stretched in the direction in which controllable elongation is desired. In this example, metal-film electrodes 733 are positioned on opposite sides of the film, separated by the film thickness. In other examples, the electrodeformable material may include a non-piezoelectric, electroactive polymer (EAP) film, in which application of electrical bias imparts tensile stress in the surrounding material layers. In some examples, the piezoelectric polymer film or non-piezoelectric EAP may comprise an auxetic material-*viz*., a structured material configured to have a negative Poisson ratio. When strain is applied in one direction to an auxetic material, strain of the same sign is created in orthogonal directions. Accordingly, an auxetic piezoelectric or non-piezoelectric EAP film may be configured to compress under electrical bias. Arranged behind strain-sensitive display layer 402, such a film may be configured to keep the display layer under compression irrespective of the direction in which the electronic-display device is folded.

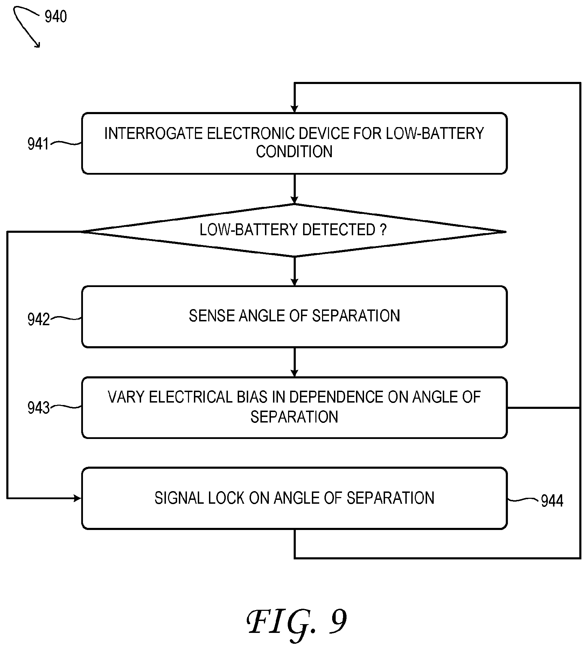

FIG. 9 shows aspects of an example method 940 to relieve bending strain in a display layer of an electronic-display device. The method may be enacted in digital logic of an integrated or peripheral computer (such as computer 407 of FIG. 4) and/or suitable analog circuitry. To that end, digital and/or analog control components may be coupled operatively to strain-relieving drive circuit 735, hinge-angle sensor, and other sensor componentry of the electronic-display device.

At optional step 941 the electronic-display device may be interrogated for a low-battery condition if the device is battery-powered. If a low-battery condition is not detected, then at 942 the angle of separation of opposing plane sections of the display layer is sensed. The angle may be sensed via a hinge-angle sensor, for example.

At 943 the electrical bias on two or more electrodes associated with an electrodeformable layer of the device is varied in dependence on the angle of separation. The electrical bias may be varied via control logic coupled operatively to an integrated strain-relieving drive circuit of the electronic-display device, for example. As noted above, such electrodes are configured to exert an electric field across the electrodeformable layer to relieve the bending strain in the electrodeformable layer. In some examples, the act of varying the electrical bias may include increasing the electrical bias with increasing angle of separation. In some examples, the applied electrical bias may vary in dependence on other factors. For instance, the elongation of some electrodeformable layers, at a given level of electrical bias, may depend on the temperature. By incorporating a temperature sensor in the electronic-display device and adjusting the value of the applied electrical bias as a function of the sensed temperature, the desired value of the elongation may be achieved more reliably. Furthermore, some electrodeformable layers may be subject to material creep and/or hardening over an extended period of time and/or usage. In a suitably calibrated system, the effects of material creep and/or hardening may be predicted and the level of the applied bias adjusted as a function of time, to compensate for such effects.

The interrogation, sensing, and varying acts of method 940 may be repeated at regular intervals as the device is being used, in order to provide optimal strain relief at whatever angle of separation. If a low-battery condition is detected, however, then at 944 a lock on the angle of separation is signaled. The lock may be signaled in various ways depending on the implementation. In some examples, a warning may be displayed on the display layer advising the user to return the device to a strain-free (*e.g*., fully open or fully closed state). In other examples, the device may automatically lock in the strain-free state, for example, via a mechanical hinge-angle lock.

In some implementations, the foregoing methods and configurations result in desirable display quality, as well as strain management, in flexible electronic-display devices. Nevertheless, additional measures may be taken to improve the display quality by reducing slack that may accumulate in a flexible display layer due to flexion. The term 'slack' refers herein to a mismatch in length between a portion of a layer and an associated portion of a substrate on which the layer is arranged. When the layer portion is at least slightly longer than the associated substrate portion, it is said to have 'slack'. In a scenario in which lateral movement of the layer relative to the substrate is restricted but the association between the two portions is maintained, the layer with slack develops more curvature than the substrate, resulting in a bulge or wrinkle. Referring again to FIG. 3A, substantially slidable coupling between display layer 302 and adjacent layers may result in a bulge or wrinkle when the electronic-display device abruptly changes conformation. That issue is addressed in electronic-display device 306B of FIG. 3B, where an electrically conductive sublayer of display layer 302 is charged electrostatically relative to electrically conductive support layer 331. Here, the opposing electric charges urge the display layer toward the electrically conductive support layer, thereby flattening the display layer against intervening dielectric layers 345. This approach provides improved display quality by reducing the occurrence of wrinkles or bulges in the display layer. As described hereinafter, such charging may be enacted continuously in some examples, or during selected conditions, such as when excessive slack in the display layer is sensed, or pursuant to an abrupt change in the opening angle of the device.

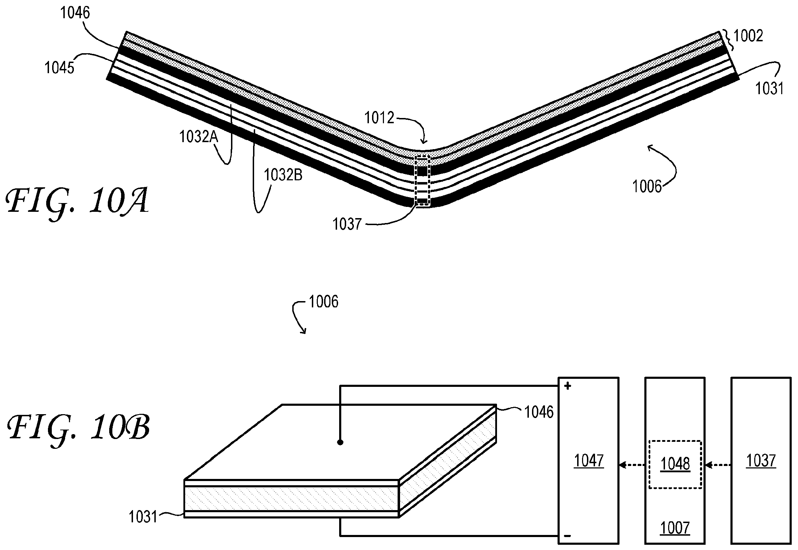

FIGS. 10A and 10B provide a more concrete example of this approach in the case of an electronic-display device sharing features of the configurations hereinabove. FIG. 10A shows aspects of a flexible electronic-display device 1006 arranged in layers. The electronic-display device is foldable in the illustrated example. The electronic-display device includes an electrically conductive support layer 1031, such as a spring steel layer. In other examples, virtually any suitably rigid and electrically conductive layer of the device may serve as the electronically conductive support layer. In any example in which the electronically conductive support layer is arranged in front of display layer 1002 (*i.e.,* between a display layer and the device user), the support layer should be optically transparent. In examples in which the support layer is arranged behind any display layer, the support layer need not be optically transparent.

The display technology operative in display layer 1002 is not particularly limited: the display layer may comprise an AMOLED, PMOLED, micro-LED or LCD layer, for example. Irrespective of the display technology, display layer 1002 may include an electrically conductive sublayer 1046 in the form of a backing layer. The backing layer may comprise a metal microfoil backing, a microwire mesh backing, or any other electrically conductive backing material. In still other examples, the electrically conductive sublayer may take the form of a front sublayer, such as an optically transparent electrode (*e.g*., cathode) common to the array of OLED or LCD pixels. Dielectric layer 1045 is arranged intermediate the electrically conductive support layer 1031 and the electrically conductive sublayer 1046 of display layer 1002.

In electronic-display device 1006, display layer 1002 is arranged slidably relative to electrically conductive support layer 1031. As noted hereinabove, the slidable arrangement between the display layer and the other layers of the device facilitates strain relief during and after flexion of the electronic-display device. In the illustrated example, the slidable coupling to the display layer is provided via elastic layer 1032. In the illustrated example, the elastic layer is arranged between the electrically conductive sublayer and the dielectric layer. In some examples, an elastic layer may be arranged between the electrically conductive support layer and the dielectric layer, additionally or alternatively. Elastic layer 1032 may include a hyperelastic and/or visco-elastic material, for example.

Turning now to FIG. 10B, electronic-display device 1006 includes a slack-reducing drive circuit 1047 configured to charge electrically conductive sublayer 1046 relative to electrically conductive support layer 1031, thereby urging (*e.g*., pulling or pushing) the display layer toward the electrically conductive support layer. For instance, in configurations where the electrically conductive sublayer is a backing of the display layer and the support layer is arranged behind the display layer, opposing electrostatic charges pull the display layer toward the electrically conductive support layer. In some configurations the electrically conductive sublayer takes the form of the common electrode of the display layer, thereby reducing the number of additional structural components required to enact the slack-management approach herein and preserving overall thinness of the electronic display device. In these and other configurations, the electrically conductive support layer is arranged behind the display layer, such that opposing electrostatic charges push the display layer toward the electrically conductive support layer. Naturally, the situation is reversed in configurations in which an optically transparent electrically conductive support layer is arranged in front of the display layer. As shown by example in FIG. 10B, slack-reducing drive circuit 1047 is coupled operatively to suitable control logic 1048 of computer 1007 and thereby configured to enact the associated methods herein.

In some examples, slack-reducing drive-circuit 1047 is configured to supply varying electrical bias between the electrically conductive sublayer and the electrically conductive support layer. This feature enables the slack-reducing drive circuit to urge the display layer toward the electrically conductive support layer under certain conditions, but to allow the display layer to relax under other conditions. In some examples, the slack-reducing drive circuit is further configured to reverse the electrical bias between the electrically conductive sublayer and the electrically conductive support layer under the direction of appropriate control logic. This feature enables the slack-reducing drive circuit to neutralize any space charge that may develop in the dielectric layers of the electronic-display device after prolonged charging.

Electronic-display device 1006 includes at least one sensor 1037 coupled operatively to control logic 1048. In the illustrated example, where the display layer includes opposing plane sections separated by an opening angle *S*, sensor 1037 may take the form of an angle sensor that furnishes an output responsive to the opening angle. In this example, slack-reducing drive circuit 1047 is configured to vary the electrical bias (*viz.,* the bias applied between the electrically conductive sublayer and the electrically conductive support layer) in dependence on a change in the opening angle as determined based on the output of the sensor. As described in further detail hereinafter, the term 'change in the opening angle' should be understood to include first and higher derivatives of the opening angle with respect to time, as well as the accumulated value of the opening angle integrated over time (*e.g*., in a proportional-integral-derivative sense).

Alternatively or in addition to the angle sensor, sensor 1037 may take the form of a deformation sensor that furnishes an output responsive to deformation (*e.g*., wrinkling, bulging, excess slack) in display layer 1002. In this example, slack-reducing drive circuit 1047 is further configured to vary the electrical bias in dependence on an output of the sensor. In more particular examples, the slack-reducing drive circuit may be controlled in a closed-loop manner so as to reduce the deformation as determined based on the output of the sensor. In some examples the deformation sensor may be an optical sensor. In other examples, the deformation sensor may be an electrical-impedance sensor. For instance, the deformation sensor may enact an AC impedance measurement responsive to the capacitance between electrically conductive support layer 1031 and electrically conducive sublayer 1046 and report when the capacitance dips below a predetermined threshold. Other types of deformation sensors are equally envisaged.

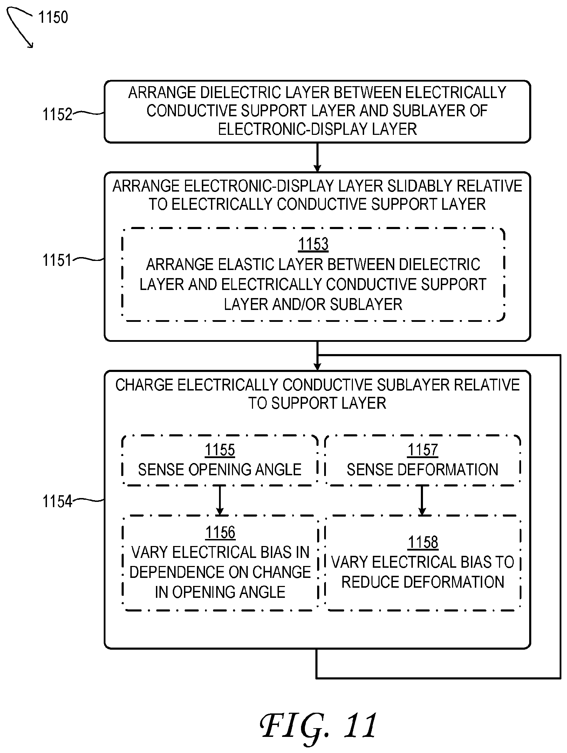

FIG. 11 shows aspects of an example method 1150 to reduce slack in a display layer of an electronic-display device. The method may be enacted in digital logic of an integrated or peripheral computer (such as computer 407 of FIG. 4) and/or suitable analog circuitry. To that end, digital and/or analog control components may be coupled operatively to slack-reducing drive circuit 1150, hinge-angle sensor 1150, and other sensor componentry of the electronic-display device.

At 1151 of method 1150, a dielectric layer is arranged between the electrically conductive support layer and an electrically conductive sublayer of the display layer. At 1152 the display layer is arranged slidably relative to an electrically conductive support layer of the electronic-display device. In some examples, the slidable arrangement of the display layer leverages the physical properties of one or more elastic layers of the electronic-display device. At 1153, accordingly, at least one elastic layer is arranged between the dielectric layer and one or both of the electrically conductive sublayer and the electrically conductive support layer.

At 1154 the electrically conductive sublayer is charged relative to the electrically conductive support layer, thereby urging the display layer toward the electrically conductive support layer. In some examples, the charging may be informed by output of a sensor coupled operatively to control logic of the onboard computer of the electronic-display device. At least categories of sensory input and control are envisaged.

In one category, where the display layer includes opposing plane sections separated by an opening angle, the opening angle, at 1155 may be sensed. At 1156 varying electrical bias is supplied between the electrically conductive sublayer and the electrically conductive support layer in dependence on a change in the opening angle. In one example scenario, the bias can be turned on or increased in real time just as an above-threshold rate of change in the opening angle *S* is sensed. When the rate of change of the opening angle drops below a threshold, the bias can be turned off or reduced. In some examples, the control logic may reverse (i.e., alternate) the direction of the bias each time that the bias is turned on in order to prevent a space charge from developing in the dielectric layer(s) intermediate the electrically conductive support layer and the electrically conductive sublayer.

In a second category, deformation of the display layer, at 1157 is sensed. At 1158 a varying electrical bias is supplied between the electrically conductive sublayer and the electrically conductive support layer so as to reduce the deformation. For instance, the electrical bias may be increased responsive to sensing an increased deformation of the display layer and decreased responsive to sensing decreased deformation of the display layer.

No aspect of the foregoing drawings or description should be understood in a limiting sense because numerous variations, extensions, and omissions are also envisaged. For instance, while the description above focuses on protecting strain-sensitive display layers, the principles herein are generally applicable to stacks of material layers subject to flexion. A stack of material layers as disclosed herein may also be used in an electromechanical actuator, for instance. Although bending and folding are the primary modes of flexion in description above, the principles herein are also applicable to the relief of strain caused by twisting a layered article. Generally speaking, twisting may impart varying amounts of expansive and compressive strain on each side of an article's neutral plane, such that active management of twisting strain requires an electrodeformable layer having a variable deformation in the length and/or width directions. Further, while the description herein focuses mainly on whole-surface bending and folding, it will be noted that flexible display layers of an electronic-display device are commonly subjected to more localized forces that may cause strain damage. Such forces include forces imparted by a touch-screen stylus tip. In principle, a locally electrodeformable layer may be used to counteract the strain caused by bending around a stylus tip. In that implementation, the sensor providing feedback for the stress or strain may be embodied as the contact-force output of the touch-screen stylus itself. Although one electrodeformable layer may be sufficient to enact appropriate strain relief for some articles, a plurality of electrodeformable layers may be used in other articles, and actuated in a co-operative manner.

Furthermore, it is to be emphasized that the strain-relieving method of FIG. 9 and the slack-reducing method of FIG. 11 are usable independently, in different devices, but also may be enacted concertedly, in the same device. To that end, a given electronic-display device may include both (a) a strain-relieving drive circuit configured to supply varying electrical bias to two or more electrodes of an electrodeformable layer, thereby inducing a dimensional change in the electrodeformable layer that relieves bending strain in the display layer; and (b) a slack-reducing drive circuit configured to charge an electrically conductive sublayer of a display layer relative to an electrically conductive support layer, thereby urging the display layer toward the electrically conductive support layer. In combined implementations, both the strain-relieving drive circuit and the slack-reducing drive circuit may be coupled operatively to suitable control logic of an onboard computer of the electronic-display device.

As noted above, the control methods herein may be tied to a computer system of one or more computing devices. Such methods and processes may be implemented as an application program or service, an application programming interface (API), a library, and/or other computer-program product.

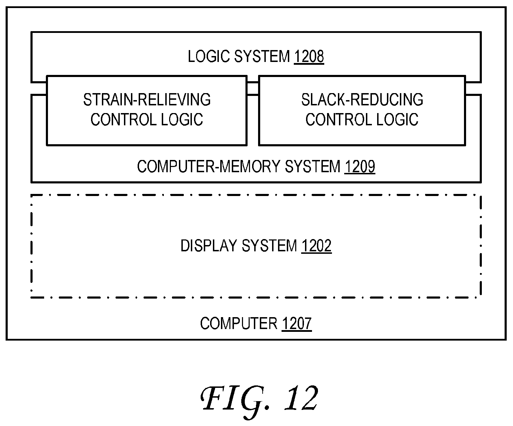

FIG. 12 provides a schematic representation of an example computer 1207 configured to provide some or all of the computer system functionality disclosed herein. Computer 1207 may define more particular variants of computer 407 of FIG. 4, in non-limiting examples. Computer 1207 of FIG. 12 includes a logic system 1208 and a computer memory system 1209. Computer 1207 may also include a display system 1202 and other systems not shown in the drawings.

Logic system 1208 includes one or more physical devices configured to execute instructions. For example, the logic system may be configured to execute instructions that are part of at least one operating system (OS), application, service, and/or other program construct. The logic system may include at least one hardware processor (*e.g*., microprocessor, central processor, central processing unit (CPU) and/or graphics processing unit (GPU)) configured to execute software instructions. Additionally or alternatively, the logic system may include at least one hardware or firmware device configured to execute hardware or firmware instructions. A processor of the logic system may be single-core or multi-core, and the instructions executed thereon may be configured for sequential, parallel, and/or distributed processing. Individual components of the logic system optionally may be distributed among two or more separate devices, which may be remotely located and/or configured for coordinated processing. Aspects of the logic system may be virtualized and executed by remotely-accessible, networked computing devices configured in a cloud-computing configuration.

Computer memory system 1209 includes at least one physical device configured to temporarily and/or permanently hold computer system information, such as data and instructions executable by logic system 1208. When the computer memory system includes two or more devices, the devices may be collocated or remotely located. Computer memory system 1209 may include at least one volatile, nonvolatile, dynamic, static, read/write, read-only, random-access, sequential-access, location-addressable, fileaddressable, and/or content-addressable computer memory device. Computer memory system 1209 may include at least one removable and/or built-in computer memory device. When the logic system executes instructions, the state of computer memory system 1209 may be transformed-*e.g*., to hold different data.

Aspects of logic system 1208 and computer memory system 1209 may be integrated together into one or more hardware-logic components. Any such hardware-logic component may include at least one program- or application-specific integrated circuit (PASIC / ASIC), program- or application-specific standard product (PSSP / ASSP), system-on-a-chip (SOC), or complex programmable logic device (CPLD), for example.

Logic system 1208 and computer memory system 1209 may cooperate to instantiate one or more logic machines or engines. As used herein, the terms 'machine' and 'engine' each refer collectively to a combination of cooperating hardware, firmware, software, instructions, and/or any other components that provide computer system functionality. In other words, machines and engines are never abstract ideas and always have a tangible form. A machine or engine may be instantiated by a single computing device, or a machine or engine may include two or more subcomponents instantiated by two or more different computing devices. In some implementations, a machine or engine includes a local component (*e.g*., a software application executed by a computer system processor) cooperating with a remote component (*e.g*., a cloud computing service provided by a network of one or more server computer systems). The software and/or other instructions that give a particular machine or engine its functionality may optionally be saved as one or more unexecuted modules on one or more computer memory devices.

Machines and engines may be implemented using any suitable combination of machine learning (ML) and artificial intelligence (AI) techniques. Non-limiting examples of techniques that may be incorporated in an implementation of one or more machines include support vector machines, multi-layer neural networks, convolutional neural networks (*e.g*., spatial convolutional networks for processing images and/or video, and/or any other suitable convolutional neural network configured to convolve and pool features across one or more temporal and/or spatial dimensions), recurrent neural networks (*e.g*., long short-term memory networks), associative memories (*e.g.,* lookup tables, hash tables, bloom filters, neural Turing machines and/or neural random-access memory) unsupervised spatial and/or clustering methods (*e.g*., nearest neighbor algorithms, topological data analysis, and/or k-means clustering), and/or graphical models (*e.g*., (hidden) Markov models, Markov random fields, (hidden) conditional random fields, and/or Al knowledge bases)).

When included, display system 1202 may be used to present a visual representation of data held by computer memory system 1209. The visual representation may take the form of a graphical user interface (GUI) in some examples. The display system may include one or more display devices utilizing virtually any type of technology. In some examples, display system may include one or more virtual-, augmented-, or mixed reality displays.

This disclosure is presented by way of example and with reference to the attached drawing figures. Components, process steps, and other elements that may be substantially the same in one or more of the figures are identified coordinately and are described with minimal repetition. It will be noted, however, that elements identified coordinately may also differ to some degree. It will be further noted that the figures are schematic and generally not drawn to scale. Rather, the various drawing scales, aspect ratios, and numbers of components shown in the figures may be purposely distorted to make certain features or relationships easier to see.

One aspect of this disclosure is directed to a flexible article comprising a plurality of material layers stacked upon each other, each material layer being thinner than a length or width of that material layer. The plurality of material layers includes a strain-sensitive layer and an electrodeformable layer configured to deform dimensionally under a varying electrical bias, the electrodeformable layer including two or more electrodes configured to receive the varying electrical bias, thereby inducing a dimensional change in the electrodeformable layer that relieves flexion strain in the strain-sensitive layer.

In some implementations, the flexion strain is an expansion strain and the electrodeformable layer is configured to contract in response to the varying electrical bias. In some implementations, the flexion strain is a compressive strain and the electrodeformable layer is configured to expand in response to the varying electrical bias. In some implementations, the plurality of material layers is configured to fold about an axis, and the strain-sensitive layer is arranged between the electrodeformable layer and the axis. In some implementations, the article further comprises a sensor furnishing an output responsive to an angle of folding about the axis and a drive circuit configured to supply the varying electrical bias to the two or more electrodes responsive to the output of the sensor. In some implementations, the electrodeformable layer comprises a piezoelectric electroactive polymer film. In some implementations, the electrodeformable layer comprises an auxetic material. In some implementations, the two or more electrodes include metal film arranged on opposite sides of the electrodeformable layer.

Another aspect of this disclosure is directed to a bendable electronic-display device comprising a display layer, an electrodeformable layer, and a drive circuit. The electrodeformable layer is configured to deform dimensionally under a varying electrical bias. The electrodeformable layer includes two or more electrodes configured to receive the varying electrical bias. The drive circuit is configured to supply the varying electrical bias to the two or more electrodes, thereby inducing a dimensional change in the electrodeformable layer that relieves bending strain in the display layer.

In some implementations, the bending strain is an expansion strain and the electrodeformable layer is configured to contract in response to the varying electrical bias. In some implementations, the display layer includes a thin-film transistor sublayer. In some implementations, the electronic-display device further comprises one or more elastic layers. In some implementations, the one or more elastic layers include two elastic layers that sandwich the electrodeformable layer. In some implementations, the electronic-display device further comprises a sensor responsive to stress or strain in the display layer, and the drive circuit is configured to vary the electrical bias in dependence on an output of the sensor. In some implementations, the display layer includes opposing plane sections separated by an opening angle, and the drive circuit is configured to vary the electrical bias in dependence on the opening angle. In some implementations, the display layer is foldable such that the opening angle is greater than 180 degrees. In some implementations, the drive circuit is a strain-relieving drive circuit, and the electronic-display device further comprises an electrically conductive support layer, a dielectric layer, and a slack-reducing drive circuit. Here the display layer includes an electrically conductive sublayer and is arranged slidably relative to the electrically conductive support layer; the dielectric layer is arranged between the electrically conductive support layer and the electrically conductive sublayer; and the slack-reducing drive circuit is configured to charge the electrically conductive sublayer relative to the electrically conductive support layer, thereby urging the display layer toward the electrically conductive support layer.

Another aspect of this disclosure is directed to a method to relieve bending strain in a display layer of an electronic-display device, the method comprising: sensing an angle of separation of opposing plane sections of the display layer; and varying, in dependence on the angle of separation, an electrical bias supplied to two or more electrodes of an electrodeformable layer of the electronic-display device, the electrodeformable layer being configured to deform dimensionally under varying electrical bias, to relieve the bending strain in the display layer.

In some implementations, varying the electrical bias includes increasing the electrical bias with increasing angle of separation. In some implementations, the method further comprises signaling a lock on the angle of separation pursuant to detecting a low-battery condition in the electronic display system.

Another aspect of this disclosure is directed to a flexible electronic-display device comprising an electrically conductive support layer, a display layer, a dielectric layer, and a drive circuit. The display layer includes an electrically conductive sublayer arranged slidably relative to the electrically conductive support layer. The dielectric layer is arranged intermediate the electrically conductive support layer and the electrically conductive sublayer. The drive circuit is configured to charge the electrically conductive sublayer relative to the electrically conductive support layer, to operatively urge the display layer toward the electrically conductive support layer.

In some implementations, the electrically conductive sublayer comprises a microfoil backing of the display layer. In some implementations, the electrically conductive sublayer comprises a common electrode of the display layer. In some implementations, the display layer comprises an organic light-emitting diode layer. In some implementations, the electronic-display device further comprises an elastic layer arranged between the electrically conductive sublayer and the dielectric layer. In some implementations, the electronic-display device further comprises an elastic layer arranged between the electrically conductive support layer and the dielectric layer. In some implementations, the electronic-display device is foldable. In some implementations, the drive circuit is configured to supply a varying electrical bias between the electrically conductive sublayer and the electrically conductive support layer. In some implementations, the drive circuit is further configured to reverse the electrical bias between the electrically conductive sublayer and the electrically conductive support layer. In some implementations, the electronic-display device further comprises a sensor responsive to deformation of the display layer, and the drive circuit is further configured to vary the electrical bias in dependence on an output of the sensor. In some implementations, the drive circuit is controlled in a closed-loop manner so as to reduce the deformation as determined based on the output of the sensor. In some implementations, the display layer includes opposing plane sections separated by an opening angle, and wherein the output of the sensor is responsive to the opening angle. In some implementations, the drive circuit is configured to vary the electrical bias in dependence on a change in the opening angle as determined based on the output of the sensor.

Another aspect of this disclosure is directed to a bendable electronic-display device comprising an electrically conductive support layer, a display layer, a dielectric layer, a slack-reducing drive circuit, an electrodeformable layer, and a strain-relieving drive circuit. The display layer includes an electrically conductive sublayer arranged slidably relative to the electrically conductive support layer. The dielectric layer is arranged intermediate the electrically conductive support layer and the electrically conductive sublayer. The slack-reducing drive circuit is configured to charge the electrically conductive sublayer relative to the electrically conductive support layer, to operatively urge the display layer toward the electrically conductive support layer. The electrodeformable layer is configured to deform dimensionally under a varying electrical bias. The electrodeformable layer includes two or more electrodes configured to receive the varying electrical bias. The strain-relieving drive circuit is configured to supply the varying electrical bias to the two or more electrodes, to operatively induce a dimensional change in the electrodeformable layer that relieves bending strain in the display layer.

In some implementations, the display layer includes opposing plane sections separated by an opening angle, and the strain-relieving drive circuit is configured to vary the electrical bias in dependence on the opening angle. In some implementations, the display layer includes opposing plane sections separated by an opening angle, the varying electrical bias is a first electrical bias, and the slack-reducing drive circuit is configured to supply a second electrical bias between the electrically conductive sublayer and the electrically conductive support layer in dependence on a change in the opening angle.

Another aspect of this disclosure is directed to a method to reduce slack in a display layer of a flexible electronic-display device, the method comprising: arranging the display layer slidably relative to an electrically conductive support layer of the electronic-display device; arranging a dielectric layer between the electrically conductive support layer and an electrically conductive sublayer of the display layer; and charging the electrically conductive sublayer relative to the electrically conductive support layer, thereby urging the display layer toward the electrically conductive support layer.

In some implementations, the method further comprises arranging at least one elastic layer between the dielectric layer and one or both of the electrically conductive sublayer and the electrically conductive support layer. In some implementations, the method further comprises sensing deformation of the display layer and supplying a varying electrical bias between the electrically conductive sublayer and the electrically conductive support layer so as to reduce the deformation. In some implementations, the display layer includes opposing plane sections separated by an opening angle, the method further comprising: sensing the opening angle; and supplying a varying electrical bias between the electrically conductive sublayer and the electrically conductive support layer in dependence on a change in the opening angle.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

## Claims

1. A flexible electronic-display device (1006) comprising a flexible electronic display comprising:
an electrically conductive support layer (1031);
a display layer (1002) including an electrically conductive sublayer (1046), wherein the display layer (1002) is arranged slidably relative to the electrically conductive support layer (1031);
a dielectric layer (1045) arranged intermediate the electrically conductive support layer (1031) and the electrically conductive sublayer (1046); and
a first drive circuit (1047) configured to charge the electrically conductive sublayer (1046) relative to the electrically conductive support layer (1031) to operatively urge the display layer (1002) toward the electrically conductive support layer (1031);
an elastic layer (1032) arranged between the electrically conductive sublayer (1046) and the dielectric layer (1045) wherein the slidable coupling to the display layer (1002) is provided via the elastic layer (1032);
wherein the device further comprises at least one sensor (1037) coupled operatively to control logic (1048) of the device, wherein the sensors is configured to sense an opening angle or deformation of the display layer; and
wherein the first drive circuit (1047) is configured to supply a varying electrical bias between the electrically conductive sublayer (1046) and the electrically conductive support layer (1031) in dependence on an output of the sensor (1037) indicating opening angle or deformation.

2. The electronic-display device of claim 1 wherein the electrically conductive sublayer (1046) comprises a microfoil backing of the display layer (1002).

3. The electronic-display device of claim 1 or 2, wherein the electrically conductive sublayer (1046) comprises a common electrode of the display layer (1002).

4. The electronic-display device of any preceding claim, wherein the display layer (1002) comprises an organic light-emitting diode layer.

5. The electronic-display device of any preceding claim further comprising an elastic layer (1032) arranged between the electrically conductive support layer and the dielectric layer.

6. The electronic-display device of any preceding claim, wherein the electronic-display device (1006) is foldable.

7. The electronic-display device of claim 1 wherein the first drive circuit (1047) is further configured to reverse the electrical bias between the electrically conductive sublayer (1046) and the electrically conductive support layer (1031).

8. The electronic-display device of claim 1, wherein the sensor (1037) comprises a deformation sensor configured to provide an output responsive to deformation in display layer (1002), wherein the first drive circuit is further configured to vary the electrical bias in dependence on an output of the sensor, wherein the first drive circuit (1047) is controlled in a closed-loop manner so as to reduce the deformation as determined based on the output of the sensor.

9. The electronic-display device of claim 1 wherein the display layer (1002) includes opposing plane sections separated by an opening angle, and wherein the sensor (1037) comprises an angle sensor configured to provide an output responsive to the opening angle, and wherein the first drive circuit (1047) is configured to vary the electrical bias applied between the electrically conductive sublayer (1046) and the electrically conductive support layer (1031) in dependence on a change in the opening angle, as determined based on the output of the sensor.

10. A bendable electronic-display device comprising:
the electronic display device of claim 1 wherein the first drive circuit defines a slack-reducing drive circuit (1047), wherein the slack reducing drive circuit (1047) is configured to operatively reduce deformation, including wrinkling bulging or excess slack in the display layer (1002);
further comprising:
an electrodeformable layer (734) configured to deform dimensionally under a varying electrical bias, the electrodeformable layer including two or more electrodes configured to receive the varying electrical bias; and
a second drive circuit (735) defining a strain relieving drive circuit, configured to supply the varying electrical bias to the two or more electrodes to operatively induce a dimensional change in the electrodeformable layer that relieves bending strain in the display layer.

11. The electronic-display device of claim 10 wherein the display layer includes opposing plane sections separated by an opening angle, and wherein the strain-relieving drive circuit is configured to vary the electrical bias in dependence on the opening angle.

12. The electronic-display device of claim 10 wherein the display layer includes opposing plane sections separated by an opening angle, wherein the varying electrical bias is a first electrical bias, and wherein the slack-reducing drive circuit is configured to supply a second electrical bias between the electrically conductive sublayer and the electrically conductive support layer in dependence on a change in the opening angle.

13. A method to reduce slack in a display layer of a flexible electronic-display device as claimed in claim 1, the method comprising:
arranging the display layer slidably relative to an electrically conductive support layer of the electronic-display device;
arranging a dielectric layer between the electrically conductive support layer and an electrically conductive sublayer of the display layer; and
charging the electrically conductive sublayer relative to the electrically conductive support layer,
thereby urging the display layer toward the electrically conductive support layer; and
further comprising arranging at least one elastic layer between the dielectric layer and one or both of the electrically conductive sublayer and the electrically conductive support layer;
sensing at least one of deformation or an opening angle of the display layer, and
supplying a varying electrical bias between the electrically conductive sublayer and the electrically conductive support layer responsive to the deformation or opening angle.

14. The method of claim 13, further comprising:
sensing deformation of the display layer, and
supplying a varying electrical bias between the electrically conductive sublayer and the electrically conductive support layer so as to reduce the deformation.

15. The method of claim 13 wherein the display layer includes opposing plane sections separated by an opening angle, the method further comprising:
sensing the opening angle; and
supplying a varying electrical bias between the electrically conductive sublayer and the electrically conductive support layer in dependence on a change in the opening angle.

## Patentansprüche

1. Eine flexible elektronische Anzeigevorrichtung (1006), die eine flexible elektronische Anzeige beinhaltet und Folgendes beinhaltet:
eine elektrisch leitende Tragschicht (1031);
eine Anzeigeschicht (1002), die eine elektrisch leitende Teilschicht (1046) umfasst, wobei die Anzeigeschicht (1002) relativ zu der elektrisch leitenden Tragschicht (1031) verschiebbar angeordnet ist;
eine dielektrische Schicht (1045), die zwischen der elektrisch leitenden Tragschicht (1031) und der elektrisch leitenden Teilschicht (1046) angeordnet ist; und
eine erste Treiberschaltung (1047), die konfiguriert ist, um die elektrisch leitende Teilschicht (1046) relativ zu der elektrisch leitenden Tragschicht (1031) zu laden, um die Anzeigeschicht (1002) operativ in Richtung der elektrisch leitenden Tragschicht (1031) zu drängen;
eine elastische Schicht (1032), die zwischen der elektrisch leitenden Teilschicht (1046) und der dielektrischen Schicht (1045) angeordnet ist, wobei die verschiebbare Kopplung mit der Anzeigeschicht (1002) über die elastische Schicht (1032) bereitgestellt wird;
wobei die Vorrichtung ferner mindestens einen Sensor (1037) beinhaltet, der operativ mit einer Steuerlogik (1048) der Vorrichtung gekoppelt ist, wobei der Sensor konfiguriert ist, um einen Öffnungswinkel oder eine Verformung der Anzeigeschicht zu erfassen; und
wobei die erste Treiberschaltung (1047) konfiguriert ist, um in Abhängigkeit von einer Ausgabe des Sensors (1037), die einen Öffnungswinkel oder eine Verformung angibt, eine variierende elektrische Vorspannung zwischen der elektrisch leitenden Teilschicht (1046) und der elektrisch leitenden Tragschicht (1031) zur Verfügung zu stellen.

2. Elektronische Anzeigevorrichtung gemäß Anspruch 1, wobei die elektrisch leitende Teilschicht (1046) eine Verstärkungsschicht der Anzeigeschicht (1002) aus ultradünner Folie beinhaltet.

3. Elektronische Anzeigevorrichtung gemäß Anspruch 1 oder 2, wobei die elektrisch leitende Teilschicht (1046) eine gemeinsame Elektrode der Anzeigeschicht (1002) beinhaltet.

4. Elektronische Anzeigevorrichtung gemäß einem der vorhergehenden Ansprüche, wobei die Anzeigeschicht (1002) eine Schicht organischer Leuchtdioden beinhaltet.

5. Elektronische Anzeigevorrichtung gemäß einem der vorhergehenden Ansprüche, die ferner eine elastische Schicht (1032) beinhaltet, die zwischen der elektrisch leitenden Tragschicht und der dielektrischen Schicht angeordnet ist.

6. Elektronische Anzeigevorrichtung gemäß einem der vorhergehenden Ansprüche, wobei die elektronische Anzeigevorrichtung (1006) faltbar ist.

7. Elektronische Anzeigevorrichtung gemäß Anspruch 1, wobei die erste Treiberschaltung (1047) ferner konfiguriert ist, um die elektrische Vorspannung zwischen der elektrisch leitenden Teilschicht (1046) und der elektrisch leitenden Tragschicht (1031) umzukehren.

8. Elektronische Anzeigevorrichtung gemäß Anspruch 1, wobei der Sensor (1037) einen Verformungssensor beinhaltet, der konfiguriert ist, um reagierend auf eine Verformung der Anzeigeschicht (1002) eine Ausgabe bereitzustellen, wobei die erste Treiberschaltung ferner konfiguriert ist, um die elektrische Vorspannung in Abhängigkeit von einer Ausgabe des Sensors zu variieren, wobei die erste Treiberschaltung (1047) in der Weise eines geschlossenen Kreises gesteuert wird, um die auf der Basis der Ausgabe des Sensors bestimmte Verformung zu reduzieren.

9. Elektronische Anzeigevorrichtung gemäß Anspruch 1, wobei die Anzeigeschicht (1002) gegenüberliegende ebene Abschnitte umfasst, die durch einen Öffnungswinkel getrennt sind, und wobei der Sensor (1037) einen Winkelsensor beinhaltet, der konfiguriert ist, um reagierend auf den Öffnungswinkel eine Ausgabe bereitzustellen, und wobei die erste Treiberschaltung (1047) konfiguriert ist, um die zwischen der elektrisch leitenden Teilschicht (1046) und der elektrisch leitenden Tragschicht (1031) angelegte elektrische Vorspannung in Abhängigkeit von einer Änderung des auf der Basis der Ausgabe des Sensors bestimmten Öffnungswinkels zu variieren.

10. Eine biegsame elektronische Anzeigevorrichtung, die Folgendes beinhaltet:
die elektronische Anzeigevorrichtung gemäß Anspruch 1, wobei die erste Treiberschaltung eine schlaffheitsreduzierende Treiberschaltung (1047) definiert, wobei die schlaffheitsreduzierende Treiberschaltung (1047) konfiguriert ist, um Verformung, einschließlich Kräuselung, Ausbuchtung oder übermäßiger Schlaffheit in der Anzeigeschicht (1002), operativ zu reduzieren;
und ferner Folgendes beinhaltet:
eine elektrisch verformbare Schicht (734), die konfiguriert ist, um sich unter einer variierenden elektrischen Vorspannung dimensional zu verformen, wobei die elektrisch verformbare Schicht zwei oder mehr Elektroden umfasst, die konfiguriert sind, um die variierende elektrische Vorspannung zu empfangen; und
eine zweite Treiberschaltung (735), die eine beanspruchungsmindernde Treiberschaltung definiert, die konfiguriert ist, um den zwei oder mehr Elektroden die variierende elektrische Vorspannung zur Verfügung zu stellen, um operativ eine dimensionale Änderung der elektrisch verformbaren Schicht zu induzieren, die die Biegebeanspruchung in der Anzeigeschicht mindert.

11. Elektronische Anzeigevorrichtung gemäß Anspruch 10, wobei die Anzeigeschicht gegenüberliegende ebene Abschnitte umfasst, die durch einen Öffnungswinkel getrennt sind, und wobei die beanspruchungsmindernde Treiberschaltung konfiguriert ist, um die elektrische Vorspannung in Abhängigkeit von dem Öffnungswinkel zu variieren.

12. Elektronische Anzeigevorrichtung gemäß Anspruch 10, wobei die Anzeigeschicht gegenüberliegende ebene Abschnitte umfasst, die durch einen Öffnungswinkel getrennt sind, wobei die variierende elektrische Vorspannung eine erste elektrische Vorspannung ist und wobei die schlaffheitsreduzierende Treiberschaltung konfiguriert ist, um zwischen der elektrisch leitenden Teilschicht und der elektrisch leitenden Tragschicht eine zweite elektrische Vorspannung in Abhängigkeit von einer Änderung des Öffnungswinkels zur Verfügung zu stellen.

13. Ein Verfahren zum Reduzieren von Schlaffheit in einer Anzeigeschicht einer flexiblen elektronischen Anzeigevorrichtung gemäß Anspruch 1, wobei das Verfahren Folgendes beinhaltet:
verschiebbares Anordnen der Anzeigeschicht relativ zu einer elektrisch leitenden Tragschicht der elektronischen Anzeigevorrichtung;
Anordnen einer dielektrischen Schicht zwischen der elektrisch leitenden Tragschicht und einer elektrisch leitenden Teilschicht der Anzeigeschicht; und
Laden der elektrisch leitenden Teilschicht relativ zu der elektrisch leitenden Tragschicht, dadurch Drängen der Anzeigeschicht in Richtung der elektrisch leitenden Tragschicht; und
ferner Folgendes beinhaltet: Anordnen mindestens einer elastischen Schicht zwischen der dielektrischen Schicht und einer oder beiden von der elektrisch leitenden Teilschicht und der elektrisch leitenden Tragschicht;
Erfassen von mindestens einem von einer Verformung oder einem Öffnungswinkel der Anzeigeschicht und
Zur-Verfügung-Stellen einer variierenden elektrischen Vorspannung zwischen der elektrisch leitenden Teilschicht und der elektrisch leitenden Tragschicht reagierend auf die Verformung oder den Öffnungswinkel.

14. Verfahren gemäß Anspruch 13, das ferner Folgendes beinhaltet:
Erfassen einer Verformung der Anzeigeschicht und
Zur-Verfügung-Stellen einer variierenden elektrischen Vorspannung zwischen der elektrisch leitenden Teilschicht und der elektrisch leitenden Tragschicht, um die Verformung zu reduzieren.

15. Verfahren gemäß Anspruch 13, wobei die Anzeigeschicht gegenüberliegende ebene Abschnitte umfasst, die durch einen Öffnungswinkel getrennt sind, wobei das Verfahren ferner Folgendes beinhaltet:
Erfassen des Öffnungswinkels; und
Zur-Verfügung-Stellen einer variierenden elektrischen Vorspannung zwischen der elektrisch leitenden Teilschicht und der elektrisch leitenden Tragschicht in Abhängigkeit von einer Änderung des Öffnungswinkels.

## Revendications

1. Un dispositif d'affichage électronique flexible (1006) comprenant une unité d'affichage électronique flexible comprenant :
une couche de soutien électroconductrice (1031) ;
une couche d'affichage (1002) incluant une sous-couche électroconductrice (1046), la couche d'affichage (1002) étant agencée de manière coulissante par rapport à la couche de soutien électroconductrice (1031) ;
une couche diélectrique (1045) agencée de manière intermédiaire entre la couche de soutien électroconductrice (1031) et la sous-couche électroconductrice (1046) ; et
un premier circuit d'attaque (1047) configuré pour charger la sous-couche électroconductrice (1046) par rapport à la couche de soutien électroconductrice (1031) afin de pousser fonctionnellement la couche d'affichage (1002) vers la couche de soutien électroconductrice (1031) ;
une couche élastique (1032) agencée entre la sous-couche électroconductrice (1046) et la couche diélectrique (1045), le couplage coulissant à la couche d'affichage (1002) étant fourni par l'intermédiaire de la couche élastique (1032) ;
le dispositif comprenant en outre au moins un détecteur (1037) fonctionnellement couplé à une logique de commande (1048) du dispositif, le détecteur étant configuré pour détecter un angle d'ouverture ou une déformation de la couche d'affichage ; et
dans lequel le premier circuit d'attaque (1047) est configuré pour apporter une polarisation électrique variable entre la sous-couche électroconductrice (1046) et la couche de soutien électroconductrice (1031) en fonction d'une sortie du détecteur (1037) indiquant un angle d'ouverture ou une déformation.

2. Le dispositif d'affichage électronique de la revendication 1 dans lequel la sous-couche électroconductrice (1046) comprend un support en microfeuille de la couche d'affichage (1002).

3. Le dispositif d'affichage électronique de la revendication 1 ou de la revendication 2, dans lequel la sous-couche électroconductrice (1046) comprend une électrode de référence de la couche d'affichage (1002).

4. Le dispositif d'affichage électronique de n'importe quelle revendication précédente, dans lequel la couche d'affichage (1002) comprend une couche de diode électroluminescente organique.

5. Le dispositif d'affichage électronique de n'importe quelle revendication précédente comprenant en outre une couche élastique (1032) agencée entre la couche de soutien électroconductrice et la couche diélectrique.

6. Le dispositif d'affichage électronique de n'importe quelle revendication précédente, le dispositif d'affichage électronique (1006) étant pliable.

7. Le dispositif d'affichage électronique de la revendication 1 dans lequel le premier circuit d'attaque (1047) est en outre configuré pour inverser la polarisation électrique entre la sous-couche électroconductrice (1046) et la couche de soutien électroconductrice (1031).

8. Le dispositif d'affichage électronique de la revendication 1, dans lequel le détecteur (1037) comprend un détecteur de déformation configuré pour fournir une sortie en réponse à une déformation dans la couche d'affichage (1002), dans lequel le premier circuit d'attaque est en outre configuré pour faire varier la polarisation électrique en fonction d'une sortie du détecteur, le premier circuit d'attaque (1047) étant commandé en boucle fermée de sorte à réduire la déformation telle que déterminée sur la base de la sortie du détecteur.

9. Le dispositif d'affichage électronique de la revendication 1, dans lequel la couche d'affichage (1002) inclut des sections planes opposées séparées d'un angle d'ouverture, et dans lequel le détecteur (1037) comprend un détecteur d'angle configuré pour fournir une sortie en réponse à l'angle d'ouverture, et dans lequel le premier circuit d'attaque (1047) est configuré pour faire varier la polarisation électrique appliquée entre la sous-couche électroconductrice (1046) et la couche de soutien électroconductrice (1031) en fonction d'un changement dans l'angle d'ouverture, tel que déterminé sur la base de la sortie du détecteur.

10. Un dispositif d'affichage électronique apte à fléchir comprenant :
le dispositif d'affichage électronique de la revendication 1, dans lequel le premier circuit d'attaque définit un circuit d'attaque de réduction de relâchement (1047), le circuit d'attaque de réduction de relâchement (1047) étant configuré pour fonctionnellement réduire la déformation, incluant un plissage, un bombage ou un relâchement excessif dans la couche d'affichage (1002) ;
comprenant en outre :
une couche électrodéformable (734) configurée pour se déformer de manière dimensionnelle sous une polarisation électrique variable, la couche électrodéformable incluant deux ou plus de deux électrodes configurées pour recevoir la polarisation électrique variable ; et
un deuxième circuit d'attaque (735) définissant un circuit d'attaque d'atténuation de déformation sous contrainte, configuré pour apporter la polarisation électrique variable aux deux ou plus de deux électrodes pour fonctionnellement induire un changement dimensionnel dans la couche électrodéformable qui atténue la déformation sous contrainte due à la flexion dans la couche d'affichage.

11. Le dispositif d'affichage électronique de la revendication 10, dans lequel la couche d'affichage inclut des sections planes opposées séparées d'un angle d'ouverture, et dans lequel le circuit d'attaque d'atténuation de déformation sous contrainte est configuré pour faire varier la polarisation électrique en fonction de l'angle d'ouverture.

12. Le dispositif d'affichage électronique de la revendication 10, dans lequel la couche d'affichage inclut des sections planes opposées séparées d'un angle d'ouverture, dans lequel la polarisation électrique variable est une première polarisation électrique, et dans lequel le circuit d'attaque de réduction de relâchement est configuré pour apporter une deuxième polarisation électrique entre la sous-couche électroconductrice et la couche de soutien électroconductrice en fonction d'un changement dans l'angle d'ouverture.

13. Un procédé pour réduire le relâchement dans une couche d'affichage d'un dispositif d'affichage électronique flexible tel que revendiqué dans la revendication 1, le procédé comprenant :
l'agencement de la couche d'affichage, de manière coulissante, par rapport à une couche de soutien électroconductrice du dispositif d'affichage électronique ;
l'agencement d'une couche diélectrique entre la couche de soutien électroconductrice et une sous-couche électroconductrice de la couche d'affichage ; et
la charge de la sous-couche électroconductrice par rapport à la couche de soutien électroconductrice, poussant ainsi la couche d'affichage vers la couche de soutien électroconductrice ; et
comprenant en outre l'agencement d'au moins une couche élastique entre la couche diélectrique et soit la sous-couche électroconductrice soit la couche de soutien électroconductrice, ou les deux ;
la détection d'au moins une caractéristique d'entre une déformation ou un angle d'ouverture de la couche d'affichage, et
l'apport d'une polarisation électrique variable entre la sous-couche électroconductrice et la couche de soutien électroconductrice en réponse à la déformation ou à l'angle d'ouverture.

14. Le procédé de la revendication 13, comprenant en outre :
la détection de la déformation de la couche d'affichage, et
l'apport d'une polarisation électrique variable entre la sous-couche électroconductrice et la couche de soutien électroconductrice de sorte à réduire la déformation.

15. Le procédé de la revendication 13 dans lequel la couche d'affichage inclut des sections planes opposées séparées d'un angle d'ouverture, le procédé comprenant en outre :
la détection de l'angle d'ouverture ; et
l'apport d'une polarisation électrique variable entre la sous-couche électroconductrice et la couche de soutien électroconductrice en fonction d'un changement dans l'angle d'ouverture.
